# EUROPÄISCHE PATENTANMELDUNG

(11) **EP 0 926 556 A2**
(43) Veröffentlichungstag der Anmeldung: **30.06.1999**
(21) Anmeldenummer: 98121624.5
(22) Anmeldetag: 12.11.1998
(51) Int. Cl.: G03F 7/20

(54) **Projektionsbelichtungsanlage und Belichtungsverfahren**

(30) Priorität: 20.12.1997 DE 19757074
(71) Anmelder: Carl Zeiss, 89518 Heidenheim (Brenz) (DE); CARL-ZEISS-STIFTUNG, trading as CARL ZEISS, 89518 Heidenheim (DE)
(72) Erfinder: Fürter, Gerhard, 73479 Ellwangen (DE)

(57) **Zusammenfassung**

Projektionsbelichtungsanlage für die FPD-Herstellung mit einem Objektivarray und vergrößernden Objektiven (O1 bis O5).

## Beschreibung

Die Erfindung betrifft eine Projektionsbelichtungsanlage mit mehreren parallel angeordneten Objektiven gemäß dem Oberbegriff des Anspruches 1 und ein Scanning-Verfahren zur mikrolithographischen Belichtung großflächiger Strukturen gemäß dem Oberbegriff des Anspruchs 14.

Aus den Offenlegungsschriften JP 7-057 986, JP 7-135 165 und JP 7-218 863 sind derartige Anlagen und Verfahren bekannt.

Bei allen ist der Abbildungsmaßstab 1:1 gewählt, laut Beschreibung z.B. von JP 7-135 165, Absatz 15 ist dies Bedingung dafür, daß Maske und belichtete Platte beim Scanning starr miteinander verbunden sein können. Während diese Schrift Linsensysteme als Projektionsobjektive vorsieht, sind bei den beiden anderen katadioptrische Projektionsobjektive vom Dyson- bzw. Offner-Typ vorgesehen.

Jeweils sind fünf bis sieben parallel arbeitende Systeme mit eigener Lichtquelle und eigener Beleuchtungsoptik vorgesehen, die Polygone als einzelne Bildfelder in zwei versetzten Zeilen aufweisen, welche beim Scanning eine gleichmäßige zeilenweise Belichtung sicherstellen.

Bei den Linsensystemen der JP 7-135 165 ist keine polygonale Beschneidung der Optiken vorgesehen. Die Umlenkspiegel der katadioptrischen Objektive bei den beiden anderen Schriften sind rechteckig dargestellt, weisen aber keinen Bezug zu den trapezförmigen oder hexagonalen Bildfeldern auf. Bei dieser Technik mit 1:1 Abbildung sind sehr großformatige Masken erforderlich.

Auch aus US 5,614,988, US 5,688,624, US 5,617,211, US 5,617,181 und EP-A 0 723 173 sind derartige Systeme bekannt.

Die Mikrolithographie zur Halbleiterherstellung arbeitet typischerweise mit Wafer-Steppern, deren Objektive 4-fach oder 5-fach verkleinernd abbilden mit einem Bildfeld von ca. 30 mm Durchmesser bei Strukturbreiten von 0,3 - 0,5 µm. Scanner erhöhen das Verhältnis von Bildfeldlänge zu -breite.

Für Flachbildschirme, etwa in LCD-Technik, werden große zusammenhängende strukturierte Flächen mit über 10 Zoll Diagonale bei Strukturbreiten von typisch 3 µm benötigt. Die Bildfelder herkömmlicher Stepperobjektive sind viel zu klein. Nach dem Step- und Repeat-Verfahren der Waferstepper würden sich unakzeptable Störstellen an den Übergängen zwischen den Belichtungszonen (Stitching) ergeben.

Aus EP-A 0 744 665 ist eine Anordnung zur Belichtung eines kompletten FPD auf einmal mit einem vergrößernden Objektiv mit einem nicht rotationssymmetrischen Element bekannt.

Aufgabe der Erfindung ist es, eine alternative Technologie für die photolithographische Herstellung großflächiger Strukturen bereitzustellen. Möglichst sollen Masken verwendet werden, die den für Mikrochips verwendeten weitgehend entsprechen.

Gelöst wird diese Aufgabe durch eine Projektionsbelichtungsanlage nach Anspruch 1 bzw. ein Verfahren nach Anspruch 14.

Demnach werden vergrößernde Projektionsobjektive bei einem Objektivarray eingeführt.

Die bei FPD benötigten Strukturbreiten sind relativ groß gegenüber dem Stand der Technik bei der Mikrochipherstellung. Es ist daher problemlos möglich, Masken mit kleinerer Strukturbreite als im Produkt bereitzustellen. Gewonnen wird dabei im quadratischen Verhältnis eine Flächenreduktion der Maske, was diese weitaus einfacher in Herstellung und Handhabung macht.

Das Scanning mit unterschiedlicher Geschwindigkeit von Maske und Wafer ist bei der Mikrochipherstellung mit weitaus höherer Genauigkeit, als bei FPD erforderlich, erprobt.

Die Erfindung geht also aus von der Erkenntnis, daß es
- zum einen eine wesentliche Vereinfachung des ganzen Prozesses darstellt, wenn die Masken (Reticles) aus etablierter Technologie der Mikrochip-Fertigung mit üblicher Größe und Strukturbreite verwendet werden können,
- es zum anderen aus der verkleinernden Scanning-Technologie der Mikrochip-Fertigung auch bei sehr engen Toleranzen beherrscht wird, Reticle und Wafer mit verschiedenen Geschwindigkeiten synchron zu bewegen.

Vorteilhafte Ausführungsformen sind Gegenstand der Unteransprüche 2-13 und 15.

Getrennte Retikel (Objektmasken) für jedes Objektiv nach Anspruch 6 ergeben einfacher beherrschbare kleine Retikel, die auch im Betrieb geregelt justiert werden können.

Durch die parallele Anordnung mehrerer Beleuchtungsoptiken nach Anspruch 7 und mehrerer Lichtquellen nach Anspruch 11 wird die Qualität der Ausleuchtung und die Leistungsfähigkeit der Anordnung (hoher Durchsatz) optimiert.

Besonders die Anpassung nach Ansprüchen 9 und 10 der größten Fassungen bzw. Linsen der Objektive an die Polygonform nach Anspruch 8 des jeweiligen Bildfelds erlaubt einen sehr kompakten Aufbau des Objektivarrays und damit eine sehr stabile und effektive streifenweise Scan-Belichtung.

Die Verwendung reiner Linsen-Objektive nach Anspruch 12 nutzt etablierte Optik-Designs und erlaubt kompakte Packung der einzelnen Elemente des Arrays, z.B. auch in mehr als zwei parallel versetzten Reihen.

Objektive mit Zwischenbild nach Anspruch 13 erlauben Anordnungen mit einteiligem Retikel.

Gemäß Anspruch 15 ist die Herstellung von Flachbildschirm-Strukturen das Hauptanwendungsgebiet der Erfindung.

Näher erläutert wird die Erfindung anhand der in der Zeichnung dargestellten Ausführungsbeispiele.

Es zeigen:
- Figur 1: schematisch in Seitenansicht eine Projektionsbelichtungsanlage für FPD-Herstellung mit einem Array vergrößernder Objektive;
- Figur 2: schematisch ein Retikel oder Retikelarray mit Streifenmasken;
- Figur 3: schematisch eine Ansicht waferseitig der Scanning-Schlitz-Bildfelder und der Objektive;
- Figur 4: schematisch eine Anordnung mit eckig beschnittenert Objektivquerschnitt;
- Figur 5: schematisch im Seitenschnitt eine Projektionsbelichtungsanlage mit einem Array vergrößernder Objektive und durchgehender Maske;
- Figur 6: schematisch eine waferseitige Ansicht der Anordnung nach Figur 5;
- Figur 7: den Linsenschnitt eines vergrößernden Projektionsobjektivs.

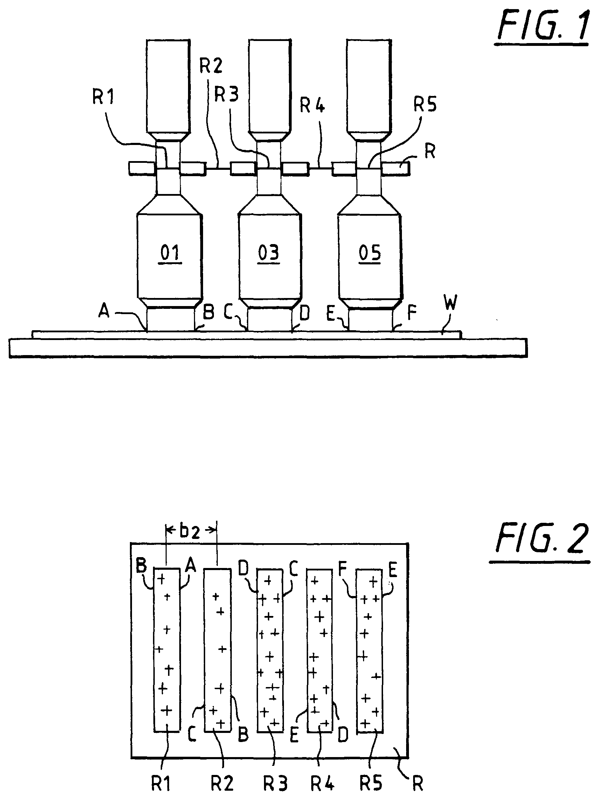

Die Anordnung der Figur 1 hat in der gezeigten Array-Zeile 3 Beleuchtungssysteme B1, B3, B5, ein Retikel oder Retikelarray R, 3 Objektive O1, O3, O5 und den Wafer W. Jedes Objektiv O1, O3, O5 vergrößert und bewirkt eine Bildumkehr, es sind normale refraktive Objektive entsprechend der Bauart der Mikrolithographie - Projektionsbelichtungsobjektive vorgesehen. Anhand Figur 7 wird unten ein Beispiel näher beschrieben.

Eine zweite Reihe (mit z.B. zwei Objektiven) von Objektiven O2, O4 ist hinter den gezeigten, den Retikelabschnitten R2 und R4 zugeordnet, angeordnet, aber der Übersichtlichkeit wegen nicht dargestellt.

Ansonsten entspricht die Gesamtanordnung wie die Komponenten weitgehend den bekannten o.g. Array-Belichtungsanlagen.

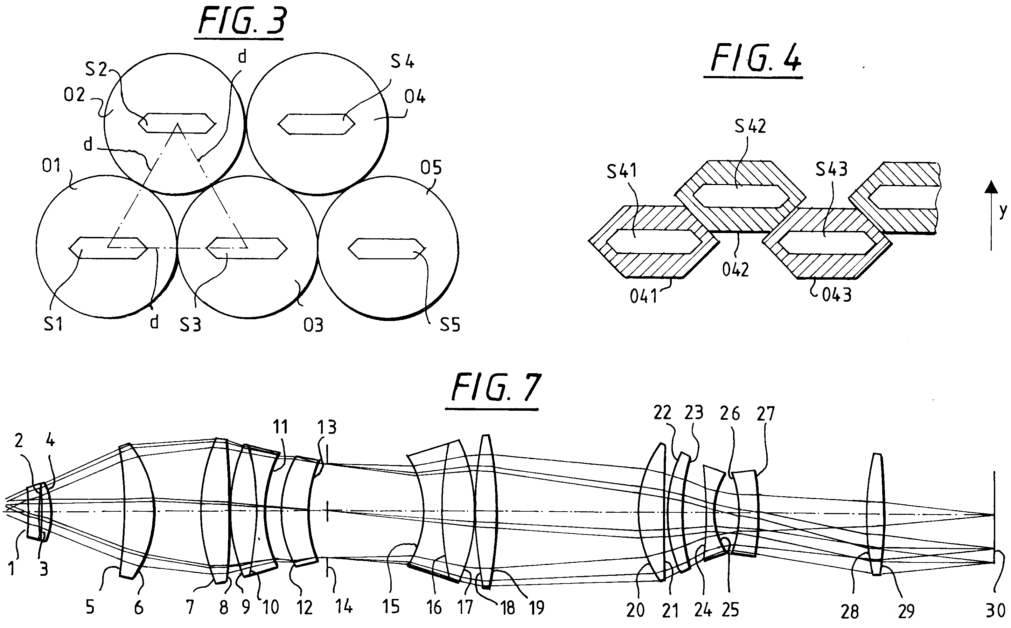

Das Retikelarray ist aber nach Figur 2 gestaltet. Seine strukturierte Fläche ist entsprechend dem Abbildungsmaßstab der Objektive O1 bis O5 kleiner als die belichtete Waferfläche. Sie ist in Streifen R1 bis R5 aufgeteilt, jeder Streifen wird von einem Objektiv O1 bis O5 abgebildet.

Da die Objektive O1 bis O5 eine Bildumkehr bewirken, sind die Strukturen auf dem Retikel gespiegelt und die bildmäßigen Anschlüsse sind wie mit den Buchstaben A, B, C, D dargestellt angeordnet.

Figur 3 zeigt eine waferseitige Ansicht mit der durch ihren Durchmesser d bestimmten dichten Packung der Objektive O1 bis O5 in zwei Reihen. Ihre Bildfelder, die Scanning-Schlitze S1 bis S5 sind so dimensioniert, daß bei Scanning in y-Richtung das ganze Bildfeld mit homogener Intensität belichtet wird. Allerdings sind die Schlitze S1 bis S5 an den Seiten dreieckförmig und überlappen in diesem Bereich. Mit dieser bekannten Maßnahme wird der Anschluß benachbarter Bereiche geglättet. Allerdings müssen dazu die Retikel-Streifen R1 bis R5 an den Rändern entsprechende Streifen zweimal mit identischer Struktur aufweisen.

Die gezeigte fünfteilige Array-Struktur ist nur ein Beispiel, jede Zeile ist beliebig anreihbar.

Das Retikel R kann am Stück mit allen strukturierten Streifen R1 bis R5 versehen werden, oder es können einzelne Streifen strukturiert werden und dann genau einjustiert auf einem Träger zu einem Array montiert werden. Es ist sogar möglich, den Abstand der einzelnen Streifen (softwaregesternert) den Erfordernissen der Bildsubstrate anzupassen, beispielsweise bei Verzug der Bildsubstrate nach Wärmebehandlung. Dies ist nur bei einem Retikelarray, nicht aber bei einem großen Einzelretikel möglich. Für diese Möglichkeit sind schon geringe Vergrößerungen der Projektionsobjektive O1 bis O5 (ab ca. 1,1 bis 1,5) ausreichend.

Figur 4 zeigt, wie die Scanningschlitze S41 bis S45 - sonst gleich wie S1 bis S5 - in y-Richtung enger gestaffelt werden können, wenn die Objektive O41 bis O45 im Querschnitt von Fassungen und/oder von Linsen eckig beschnitten werden. Das geht, wenn die objektseitigen Linsen deutlich größer als die aperturnahen Linsen sind und den Objektivquerschnitt bestimmen.

Die Beleuchtungseinrichtungen B1 bis B5 (Fig. 1) müssen im Querschnitt jeweils in das Maß der Objektive O1 bis O5, O41 bis O45 passen. Dies gelingt jedoch leicht, da sie nur das kleinere Retikel-Feld ausleuchten.

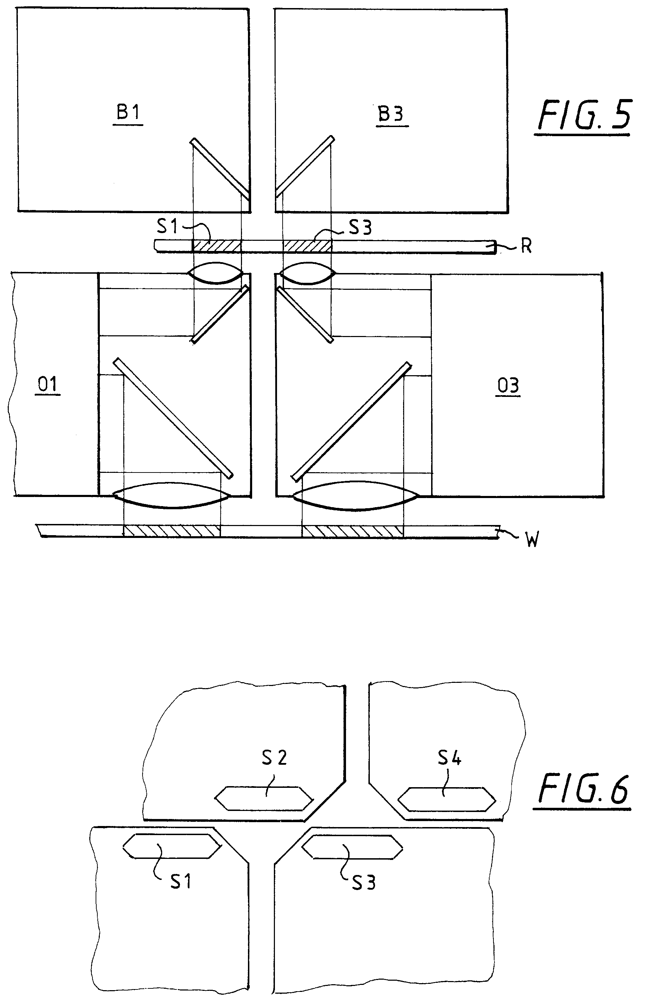

Eine Variante, die mit einer einteiligen zusammenhängenden Maske auf dem Retikel R5 auskommt, ist in Figur 5 im schematischen Seitenschnitt und in Figur 6 in waferseitiger Ansicht gezeigt. Hierzu ist es erforderlich, daß das gegenstandsseitige (retikelseitige) Feld der Projektionsobjektive O51 bis O54 Seitenversatz gegenüber dem Bildfeld zeigt und daß eine Bildumkehr erfolgt. Dies wird durch katadioptrische Objektive mit Zwischenbild ermöglicht. Auch reine Spiegelobjektive sind möglich.

Derartige Objektive O51 bis O55 können z.B. aus bekannten verkleinernden Mikrolithographie-Projektionsobjektiven mit Zwischenbild abgeleitet werden, bei denen Objekt- und Bildebene getauscht werden. Ein Beispiel ist z.B. in EP 0 736 789 A2 veröffentlicht.

Zurück zur Anordnung der Figur 1 mit refraktiven Objektiven O1 bis O5. Ein Ausführungsbeispiel für ein solches Objektiv ist mit seinen Designdaten in Tabelle 1 und dem Linsenschnitt in Figur 7 dargestellt.

Das Objektiv ist für eine Quecksilber-Entladungslampe mit der Linie 436 nm ausgelegt, hat eine vierfache Vergrößerung bei einer bildseitigen numerischen Apertur von 0,1 (objektseitig 0,4) und einer größten Bildhöhe y' = 26 mm. Die Baulänge 00' ist 558 mm, der größte Linsendurchmesser 82 mm. Das Objektiv zeigt den typischen Aufbau von refraktiven Mikrolithographie-Projektionsbelichtungsobjektiven, nur eben vergrößernd eingesetzt. Der RMS-Bildfehler ist für alle Bildhöhen kleiner als 0,032, das Strehl-Verhältnis größer als 0,96.

Die angegebenen Glasarten sind optische Gläser aus dem Katalogangebot der Firma Schott Glaswerke in Mainz.

**TABELLE I**

| Fläche | Radien | Dicken | Gläser |
|---|---|---|---|
| 0 | Objekt | 5.760 | |
| 1 | -163.237 | 5.958 | SF1 |
| 2 | 148.818 | 2.164 | |
| 3 | -121.380 | 4.027 | SK4 |
| 4 | -43.985 | 42.794 | |
| 5 | -201.332 | 15.134 | LAK8 |
| 6 | -62.781 | 27.567 | |
| 7 | 108.987 | 15.665 | LAK10 |
| 8 | -452.162 | 0.286 | |
| 9 | 95.420 | 13.971 | KF6 |
| 10 | -218.175 | 5.001 | SF53 |
| 11 | 66.388 | 10.333 | |
| 12 | 63.538 | 13.994 | SF2 |
| 13 | 62.997 | 10.640 | |
| 14 | unendl. (Blende) | 54.848 | |
| 15 | -49.639 | 9.957 | F5 |
| 16 | 168.252 | 18.229 | SK15 |
| 17 | 91.334 | 0.254 | |
| 18 | 223.051 | 10.996 | LAKN12 |
| 19 | -269.170 | 80.447 | |
| 20 | 67.223 | 14.930 | LAKN12 |
| 21 | 874.124 | 1.009 | |
| 22 | 70.226 | 8.401 | BK7 |
| 23 | 106.330 | 13.736 | |
| 24 | -283.133 | 3.272 | BK7 |
| 25 | 34.468 | 15.000 | |
| 26 | -51.704 | 10.498 | LAF2 |
| 27 | -217.317 | 61.721 | |
| 28 | 141.298 | 9.427 | LAK8 |
| 29 | -333.793 | 11.981 | |
| 30 | Bild | | |

## Patentansprüche

1. Projektionsbelichtungsanlage mit mehreren parallel angeordneten Objektiven (O1 bis O5), dadurch gekennzeichnet, daß die Objektive (O1 bis O5) vergrößern.

2. Projektionsbelichtungsanlage nach Anspruch 1, dadurch gekennzeichnet, daß die Objektive mit einem Maßstab größer als 1:1,1 - vorzugsweise größer als 1:1,5 - vergrößern.

3. Projektionsbelichtungsanlage nach Anspruch 1, dadurch gekennzeichnet, daß sie vom Scanning-Typ ist.

4. Projektionsbelichtungsanlage nach Anspruch 3, dadurch gekennzeichnet, daß die Objektive (O1 bis O5) senkrecht zur Scanrichtung in zwei oder mehr Reihen mit Versatz angeordnet und so ausgebildet sind, daß die Einzelbildfelder beim Scannen entweder nahtlos aneinandergesetzt werden oder sich überlappen.

5. Projektionsbelichtungsanlage nach Anspruch 4, dadurch gekennzeichnet, daß das Bildfeld (S1 bis S5) so geformt ist, daß beim Scannen auch im Überlappbereich jeder Bildpunkt im wesentlichen dieselbe Gesamtlichtdosis erzielt.

6. Projektionsbelichtungsanlage nach mindestens einem der Ansprüche 1-5, dadurch gekennzeichnet, daß jedem Objektiv eine eigene Objektmaske (Retikel) zugeordnet ist.

7. Projektionsbelichtungsanlage nach mindestens einem der Ansprüche 1-6, dadurch gekennzeichnet, daß jedem Objektiv (O1 bis O5) eine eigene Beleuchtungseinrichtung (B1 bis B5) zugeordnet ist.

8. Projektionsbelichtungsanlage nach mindestens einem der Ansprüche 1 bis 7, dadurch gekennzeichnet, daß das Bildfeld (S1 bis S5) jedes Objektivs (O1 bis O5) Polygonform hat.

9. Projektionsbelichtungsanlage nach Anspruch 8, dadurch gekennzeichnet, daß eine oder mehrere Fassungen jedes Objektivs (O41 bis O45) in Polygonform beschnitten sind.

10. Projektionsbelichtungsanlage nach Anspruch 8, dadurch gekennzeichnet, daß eine oder mehrere Linsen jedes Objektivs (O41 bis O45) in Polygonform beschnitten sind.

11. Projektionsbelichtungsanlage nach Anspruch 7, dadurch gekennzeichnet, daß jeder Beleuchtungseinrichtung (B1 bis B5) eine gesonderte Lichtquelle zugeordnet ist.

12. Projektionsbelichtungsanlage nach mindestens einem der Ansprüche 1-11, dadurch gekennzeichnet, daß die Objektive (O1 bis O5) reine Linsenobjektive sind.

13. Projektionsbelichtunganlage nach mindestens einem der Ansprüche 1-11, dadurch gekennzeichnet, daß die Objektive (O51 bis O54) Objektive mit Zwischenbild sind.

14. Verfahren zur mikrolithographischen Belichtung großflächiger Strukturen mit Scanning mit mehreren Objektiven (O1 bis O5), die effektiv eine Scanningzeile abbilden, dadurch gekennzeichnet, daß die Strukturvorlage (R1 bis R5) vergrößert mit einem Maßstab über 1:1,1 - vorzugsweise über 1:1,5 - abgebildet wird.

15. Verfahren nach Anspruch 14, dadurch gekennzeichnet, daß die Strukturen Flachbildschirmstrukturen sind.
